(19) **Europäisches Patentamt**
**European Patent Office**
**Office européen des brevets**

(11) **EP 2 492 251 B1**

(12) **EUROPÄISCHE PATENTSCHRIFT**

(45) Veröffentlichungstag und Bekanntmachung des Hinweises auf die Patenterteilung:
**04.01.2017 Patentblatt 2017/01**

(51) Int Cl.:
***C03C 17/34*** *(2006.01)*

(21) Anmeldenummer: **12000797.6**

(22) Anmeldetag: **08.02.2012**

(54) **Substrat mit Antireflexionsbeschichtung und Verahren zu dessen Herstellung**

Substrate with antireflective coating and method for producing same

Substrat doté d'un revêtement anti-réfléchissant et son procédé de fabrication

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.02.2011 DE 102011012160**
**20.01.2012 DE 102012000997**

(43) Veröffentlichungstag der Anmeldung:
**29.08.2012 Patentblatt 2012/35**

(73) Patentinhaber: **SCHOTT AG**
**55122 Mainz (DE)**

(72) Erfinder:
• **Henn, Christian**
**55546 Frei-Laubersheim (DE)**
• **Damm, Thorsten Dr.**
**55268 Nieder-Olm (DE)**

(74) Vertreter: **Herden, Andreas F.**
**Blumbach & Zinngrebe**
**Alexandrastrasse 5**
**65187 Wiesbaden (DE)**

(56) Entgegenhaltungen:
| | |
|---|---|
| EP-A1- 1 148 037 | EP-A1- 2 149 540 |
| WO-A1-01/37006 | WO-A1-2009/051595 |
| WO-A1-2009/071667 | WO-A1-2010/127845 |
| DE-A1- 3 941 796 | DE-A1-102006 046 312 |
| FR-A1- 2 841 894 | FR-A1- 2 861 386 |
| FR-A1- 2 889 182 | FR-A1- 2 898 295 |
| JP-A- 2004 271 480 | JP-A- 2006 275 526 |

EP 2 492 251 B1

**Beschreibung**

Die Erfindung betrifft allgemein Antireflexionsbeschichtungen, beziehungsweise mit Antireflexionsbeschichtungen versehene Träger. Insbesondere betrifft die Erfindung Antireflexionsbeschichtungen mit hoher Widerstandsfähigkeit gegen Verkratzen oder anderweitige Abnutzungen.

Antireflexionsbeschichtungen werden heutzutage vielfach dafür eingesetzt, die Transmission transparenter Substrate, wie etwa von Sichtscheiben zu verbessern oder andererseits störende Reflexe am Substrat abzuschwächen. Je nach Verwendungszweck des Substrats kann die Antireflexionsbeschichtung allerdings hohen Abnutzungsbelastungen ausgesetzt sein. Beispielsweise treffen auf eine Aussenbeschichtung einer Fahrzeug-Sichtscheibe während der Fahrt Sand- und Staubpartikel mit hoher Geschwindigkeit auf und können die Beschichtung im Laufe der Zeit abtragen. Eine besondere Belastung entsteht bei solchen Scheiben auch, wenn ein Scheibenwischer über die verschmutzte Scheibe geführt wird. Die Sand- und Staubpartikel werden dabei nicht nur über die Scheibe befördert, sondern gleichzeitig durch die Gummilippe des Scheibenwischers gegen die Scheibe gepresst. In der Beschichtung können auf diese Weise lange Kratzer entstehen.

Kratzer und andere Beschädigungen führen zu Trübungen und wirken daher dem Zweck einer Antireflex-Beschichtung gerade entgegen. Darüber hinaus wird die Sicht des Fahrers beeinträchtigt.

Es besteht daher Bedarf an einer Antireflex-Beschichtung mit einer hohen Widerstandsfähigkeit gegen Verkratzen und Abrieb.

Aus der US 2005/0074591 A1 ist ein transparentes Substrat mit einer abriebfesten Antireflexbeschichtung bekannt. Die Antireflexbeschichtung wird aus vier Lagen mit abwechselndem hohen und niedrigem Brechungsindex zusammengesetzt. Die niedrigbrechenden Schichten bestehen aus Siliziumoxid ($SiO_2$), die hochbrechenden Schichten aus Siliziumnitrid ($Si_3N_4$) oder Zinnoxid ($SnO_2$).
Die oberste Schicht des Schichtstapels wird dabei aus einer niedrigbrechenden Schicht gebildet. Nachteilig ist hier, dass die niedrigbrechende Siliziumoxidschicht verglichen mit den hochbrechenden Materialien, insbesondere verglichen mit $Si_3N_4$ sehr weich ist. Gerade die oberste Schicht kann sich daher nach wie vor schnell abnutzen. Ist die oberste Schicht abgetragen, so bildet dann eine hochbrechende Schicht die Oberfläche. Dies führt zu einer Umkehrung des Entspiegelungs-Effekts. Die Schicht wirkt nun also eher wie ein dielektrischer Spiegel.

Die WO 2001/37006 A1 beschreibt eine Antireflexbeschichtung der Schichtabfolge Glas/$Si_3N_4$/$SiO_2$/$Si_3N_4$/$SiO_2$, wobei die $SiO_2$-Schichten 10 Gewichtsprozent Aluminiumoxid enthalten. Aluminiumhaltige $Si_3N_4$- und $SiO_2$-Schichten für eine Antireflexbeschichtung sind auch aus der FR 2 898 295 A1, der FR 2 841 894 A1, sowie für eine Hitzeschutzverglasung aus der FR 2 889 182 A1 bekannt. Antireflexbeschichtungen mit alternierenden Siliziumoxid-Siliziumnitridschichten sind weiterhin auch aus der EP 2 149 540 A1, der JP 2004 271480 A und der JP 2006-275526 A bekannt.
Die FR 2 861 386 A1 beschreibt in Vergleichsbeispiel 3 ein Schichtsystem mit einer aluminiumdotierten $SiO_2$-Schicht auf Glas, einer darauf abgeschiedenen $TiO_2$-Schicht und einer abschließenden aluminiumdotierten $Si_3N_4$-Schicht. Eine solche Schicht nach Vergleichsbeispiel 3 erweist sich gegenüber einem Schichtstapel aus einer zwischen zwei aluminiumdotierten $SiO_2$-Schichten eingebetteten $TiO_2$-Schicht als weniger widerstandsfähig bei einem Abrieb-Test (TABER-Test).

Der Erfindung liegt daher die Aufgabe zugrunde, die Abriebfestigkeit von Entspiegelungsschichten weiter zu verbessern. Weiterhin ist es Aufgabe der Erfindung, ein Schichtsystem bereit zu stellen, welches die Reflexion einer Scheibe, insbesondere einer Sichtscheibe von typischerweise etwa 4% auf kleiner 1% zu reduzieren und gleichzeitig die mechanische Beständigkeit der Substratoberfläche stark zu erhöhen.

Diese Aufgabe wird durch den Gegenstand der unabhängigen Ansprüche gelöst. Vorteilhafte Ausgestaltungen und Weiterbildungen der Erfindung sind in den jeweiligen abhängigen Ansprüchen angegeben.

Demgemäß sieht die Erfindung ein beschichtetes Substrat vor, welches

- auf zumindest einer Seite eine mehrlagige Antireflexbeschichtung aufweist, welche
- aus Lagen mit verschiedenen Brechungsindizes aufgebaut ist, wobei sich Lagen mit höherem und Lagen mit niedrigerem Brechungsindex abwechseln, wobei
- die Lagen mit niedrigerem Brechungsindex aus Siliziumoxid mit einem Anteil von Aluminium aufgebaut sind, bei welchen
- das Verhältnis der Stoffmengen von Aluminium zu Silizium größer als 0,05, vorzugsweise größer als 0,08 beträgt, die Stoffmenge von Silizium aber gegenüber der Stoffmenge von Aluminium überwiegt, und wobei
- die Lagen mit höherem Brechungsindex ein Silizid, Oxid oder Nitrid enthalten. Besonders geeignet für die hochbrechenden Schichten ist Siliziumnitrid.

Mit anderen Worten weisen die erfindungsgemäßen niedrigbrechenden Schichten ein Verhältnis der Stoffmengen von Silizium zu Aluminium gemäß folgender Beziehung auf:

$$n(Al)/(n(Si)+n(Al)) > 0,05 ,$$

wobei n(Al) die Stoffmenge von Aluminium und n(Si) die Stoffmenge von Silizium bezeichnen.

Es hat sich überraschend gezeigt, dass die Beimischung von Aluminium, beziehungsweise Aluminiumoxid den im Vergleich zu den hochbrechenden Siliziumnitrid-Lagen weichen, niedrigbrechenden Siliziumoxid-Lagen eine deutlich höhere Beständigkeit gegen Verkratzen und Abrieb verleiht.

Das Verfahren zur Herstellung eines solchen beschichteten Substrats basiert entsprechend darauf, dass

- auf zumindest einer Seite des Substrats eine mehrlagige Antireflexbeschichtung aufgebracht wird, welche
- durch sukzessive Abscheidung aus Lagen mit verschiedenen Brechungsindizes aufgebaut wird, wobei sich Lagen mit höherem und Lagen mit niedrigerem Brechungsindex abwechseln, wobei
- die Lagen mit niedrigerem Brechungsindex aus Siliziumoxid mit einem Anteil von Aluminium aufgebaut werden, bei welchen
- das Verhältnis der Stoffmengen von Aluminium zu Silizium größer als 0,05, vorzugsweise größer als 0,08 beträgt, die Stoffmenge von Silizium aber gegenüber der Stoffmenge von Aluminium überwiegt, und wobei
- Oxid- Silizid- oder Nitrid-haltige, besonders bevorzugt Siliziumnitrid-haltige Lagen als Lagen mit höherem Brechungsindex abgeschieden werden.

Als bevorzugte Abscheidemethode für die Lagen der Antireflexionsbeschichtung wird Sputtern, insbesondere Magnetronsputtern verwendet. Hierbei ist weiterhin reaktives Sputtern besonders vorteilhaft, da in diesem Fall sowohl das Siliziumoxid der niedrigbrechenden Lagen, als auch das bevorzugt verwendete Siliziumnitrid für die hochbrechenden Lagen mit dem gleichen Target hergestellt werden können. Die Umschaltung auf die verschiedenen Schichtmaterialien kann einfach durch Änderung der Prozessparameter, insbesondere der Zusammensetzung des Prozessgases erfolgen.

In bevorzugter Ausführungsform wird die Oberfläche der Antireflexbeschichtung durch eine Lage mit niedrigerem Brechungsindex aus Siliziumoxid mit einem Anteil von Aluminium gebildet. Dies ist günstig, um einen möglichst kleinen Brechungsindex-Sprung an der Grenzfläche der Beschichtung zur Umgebung und damit eine besonders gute Antireflex-Wirkung zu erzielen. Gerade hier zeigt sich der besondere Vorteil der Erfindung, da durch die erfindungsgemäße Schichtzusammensetzung der niedrigbrechenden obersten Schicht ein schneller Abrieb dieser Schicht vermieden wird.

Die Aluminiumdotierung sollte vorzugsweise nicht mehr als 20 Mol-Prozent des Silizium-Gehaltes betragen. Mit anderen Worten wird bevorzugt, dass das Verhältnis der Stoffmengen von Aluminium zu Silizium höchstens 0,2 beträgt. Dementsprechend gilt dann für die Stoffmengen n(Si) und n(Al) von Silizium, beziehungsweise Aluminium:

$$n(Al)/(n(Si)+n(Al)) = x,$$

mit x im Bereich von 0,05 bis 0,2

Wird der Aluminium-Gehalt zu groß, so ergibt sich schließlich aufgrund des steigenden Brechungsindex der niedrigbrechenden Schichten eine Abnahme der Entspiegelungs-Wirkung.

Gemäß einer weiteren besonders bevorzugten Ausführungsform der Erfindung werden auch die Lagen mit höherem Brechungsindex als aluminiumhaltige Siliziumnitrid-Lagen aufgebaut. Dementsprechend bestehen diese Schichten dann aus Siliziumnitrid mit einem Anteil von Aluminium, bei welchen das Verhältnis der Stoffmengen von Aluminium zu Silizium größer als 0,05, vorzugsweise größer als 0,08 beträgt.

Insbesondere kann der Aluminiumgehalt relativ zum Siliziumgehalt in den hoch- und niedrigbrechenden Schichten gleich, beziehungsweise im Wesentlichen gleich sein. Um einen derartigen Schichtstapel herzustellen, können alle Schichten durch reaktives Sputtern von einem aluminiumdotierten Siliziumtarget abgeschieden werden. Das Verfahren ist dementsprechend besonders einfach, da ein Wechsel des Targets entfallen kann.

Entsprechend gelten dann für die hochbrechenden Siliziumnitrid-Schichten entsprechende Verhältnisse der Stoffmengen von Silizium und Aluminium, wie oben angegeben, also n(Al)/(n(Si)+n(Al)) > 0,05 vorzugsweise im Bereich von 0,05 bis 0,2.

Es hat sich überraschend gezeigt, dass eine erfindungsgemäße Antireflexionsschicht bereits mit vergleichsweise dünnen Schichtdicken einen langlebigen Kratzschutz bereitstellt. So weist die Antireflexionsbeschichtung in bevorzugter Ausführung eine Schichtdicke im Bereich von insgesamt 200 bis 400 Nanometern auf. Besonders bevorzugte Schichtdicken liegen im Bereich von 250 bis 300 Nanometern. Zum Vergleich sind typische Kratzschutz- oder Hartstoffbeschichtungen allgemein mehr als 1 Mikrometer dick.

Als Substrate kommen bevorzugt anorganische Werkstoffe, wie Gläser und transparente und opake Glaskeramiken, auch Saphir-Gläser, synthetisches Quarzglas (Fused Silica)oder Kristalle für beispielsweise optische Zwecke, wie Calciumfluorid in Betracht. Besonders geeignet sind scheibenförmige Substrate. Auch Verbundmaterialien, insbesondere mit Gläsern, wie sie beispielsweise als Fahrzeugverglasungen verwendet werden, sind geeignet. Dabei kann der Verbund auch nach dem Beschichten mit der Antireflexionsbeschichtung erzeugt werden. Zur Herstellung eines solchen Verbundes werden beispielsweise zwei Glasscheiben mit einer PVB-Folie miteinander verbunden. Bevorzugte Gläser als Substrate sind Borosilikatgläser, wie Borofloatgläser, Aluminosilikatgläser, Lithiumaluminosilikatgläser, Kalk-Natrongläser und Glaskeramiken. Weiterhin können auch optische Gläser und Filtergläser als Substrate verwendet werden.

Die Schichteigenschaften können weiterhin sehr vorteilhaft durch ein besonderes Sputterverfahren günstig beeinflusst werden. Dieses Verfahren wird im Folgenden als HiPIMS Verfahren (High Power Impulse Magnetron Sputtering), oder auch HPPMS-Verfahren (High Power Pulse Magnetron Sputtering) bezeichnet. Dieses Abscheideverfahren auch in der WO 2010/127845 A1 beschrieben wird, stellt ein gepulstes Sputterverfahren dar, bei dem hochenergetische Pulse erzeugt werden, die zu hohen Leistungsdichten auf dem Target deutlich über die für das Sputtern typischen 10W/cm² führen.

Im Speziellen ist gemäß der Erfindung vorgesehen, dass zumindest eine, vorzugsweise mehrere, besonders bevorzugt alle Lagen der mehrlagigen Antireflexionsbeschichtung durch Magnetronsputtern abgeschieden werden, wobei zur Anregung des Plasmas ein gepulstes Feld verwendet wird, wobei die Pulse eine Leistungsdichte von mindestens 100 Watt pro Quadratzentimeter der Targetfläche aufweisen. Die Leistungsdichte kann durchaus auch 1000 Watt pro Quadratzentimeter überschreiten. Ein bevorzugter Leistungsbereich liegt zwischen 100 und 2000 W/cm2. Für das Feld werden vorzugsweise Pulsfrequenzen im Bereich 100 Hz bis 10.000Hz, besonders bevorzugt im Bereich von 500Hz bis 2 kHz verwendet. Weiterhin ist es günstig, im Vergleich mit der Pulsdauer lange Pulspausen vorzusehen. Vorzugsweise ist die Pulspause zwischen zwei Pulsen mindestens um einen Faktor fünf länger als die Pulsdauer.

Die hohen Leistungsdichten führen dazu, dass die aus dem Target herauskatapultierten Partikel einer höheren Energie als beim konventionellen Sputtern aufweisen. Es lassen sich nicht nur Neutralteilchen, sondern darüber hinaus vermehrt auch elektrisch geladene Partikel (Ionen) erzeugen. Dabei ist der Anteil von Ionen wesentlich höher als beim konventionellen Sputtern.

Die höhere Energie der Partikel führt zu einer höheren Mobilität auf der Substratoberfläche und begünstigt dadurch das Wachstum der Schicht im Hinblick auf Dichte und geringe Porosität. Durch geeignete Prozessparameter, insbesondere Pulsparameter kann die Oberflächentopografie der gesputterten Schicht modifiziert werden. Es können diverse Oberflächenstrukturen und Rauheiten eingestellt werden. Das Wachstum lässt sich darüber hinaus durch Heizen des Substrates beeinflussen.

Es zeigt sich, dass die mit diesem Verfahren hergestellten erfindungsgemäßen Schichten nicht nur sehr dicht werden, sondern vor allem auch eine extrem glatte Oberfläche aufweisen. Gerade dies scheint die mechanische Beständigkeit gegen Verkratzen oder Abrasion besonders zu erhöhen, da die Schichtoberfläche kaum Angriffspunkte bietet, beziehungsweise sich Beschädigungen nicht ausgehend von Unregelmäßigkeiten der Beschichtung ausbreiten können.

Es werden mit diesem Verfahren Schichten, beziehungsweise Schichtoberflächen erzeugt, welche einen Wert der quadratischen Rauheit (auch als RMS-Wert bezeichnet) von weniger als 1,5 Nanometern, sogar von weniger als 1 Nanometer, bezogen auf eine Fläche von 1 Quadratmikrometer aufweisen. Die gleichen Werte gelten auch für die mittlere Rauheit Ra. Tendenziell ist die mittlere Rauheit sogar noch etwas niedriger als die quadratische Rauheit.

Gemäß der Erfindung weist die Oberfläche der Antireflexbeschichtung, beziehungsweise der obersten Lage der Antireflexbeschichtung also eine mittlere Rauheit und eine quadratische Rauheit auf, die bezogen auf eine Fläche von einem Quadratmikrometer jeweils weniger als 1,5 Nanometer, vorzugsweise weniger als 1 Nanometer beträgt. Das HiPIMS-Verfahren weist gegenüber herkömmlichem Magnetronsputtern noch den Nachteil auf, dass die Abscheideraten geringer sind. Als vorteilhaft hat sich dabei eine Kombination aus dem HiPIMS-Sputterverfahren mit herkömmlichen Mittelfrequenz-, DC- oder HF-Sputterverfahren erwiesen. Die bei HiPIMS reduzierte Rate kann dadurch teilweise kompensiert werden, wobei positive Aspekte der höherenergetischen HiPIMS-Partikel nicht verloren gehen.

Durch die Überlagerung von HiPIMS mit einem konventionellen Sputterverfahren kann die Energie des HiPIMS-Pulses besser eingekoppelt werden, da hier das Plasma in der langen Pulsaus-Zeit durch die Überlagerung nicht komplett verlöscht. Wesentlich für diese Weiterbildung der Erfindung ist also weniger, dass in den Pulspausen weiter Material gesputtert, sondern vielmehr, dass in den Pausen zwischen den Pulsen das Plasma aufrechterhalten wird. Der Prozess kann durchaus so eingestellt werden, dass in den Pulspausen kein, oder zumindest kein wesentlicher Schichtaufbau erfolgt.

Die Aufrechterhaltung des Plasmas in den Pulspausen kann beispielsweise durch Überlagerung der HiPIMS Pulssignale mit DC-Spannung oder Mittelfrequenz-Wechselspannungen erfolgen. Der Einsatz von MF-Sputtern reduziert darüber hinaus das Arcing (elektrische Überschläge) bei reaktiven (HiPIMS-)Sputterprozessen. Dadurch wird die Anzahl der Defekte der deponierten Schicht (Pinholes, lokale Aufschmelzungen, Droplets) reduziert. Dieser Aspekt verbessert die mechanische Beständigkeit von Hartstoffschichten der erfindungsgemäßen Antireflexbeschichtung, also insbesondere der bevorzugt eingesetzten Siliziumnitrid-Lagen.

Um einerseits eine gute Kratzschutz-Wirkung und andererseits eine gute Entspiegelung zu erzielen, ist es günstig, wenn die Antireflexbeschichtung zumindest zwei Lagen mit höherem Brechungsindex und zumindest zwei Lagen mit niedrigerem Brechungsindex aufweist. Ist das SubstratMaterial deutlich weicher als die höherbrechenden Siliziumnitrid-Lagen, so ist es dabei weiterhin günstig, mit einer Siliziumnitrid-Lage zu beginnen. Dementsprechend wird dabei die unterste Lage der Antireflexbeschichtung durch eine Lage mit höherem Brechungsindex gebildet. Wird ein hartes Substrat verwendet, wie beispielsweise ein Saphirglas, ist es demgegenüber günstig, als unterste Lage eine niedrigbrechende aluminiumdotierte Siliziumoxidschicht zu verwenden.

Das Schichtsystem der erfindungsgemäßen Antireflexbeschichtung ist überall dort einsetzbar, wo antireflektierende Schichtsysteme mechanischer Belastung ausgesetzt werden. Die Herstellung kann durch konventionelle Sputtertechnologie, als auch für eine weiter verbesserte mechanische Festigkeit mit der HiPiMS Technologie erfolgen. Mögliche Anwendungen sind der Einsatz bei Sichtscheiben im Fahrzeugbereich einschließlich von Luftfahrzeugen, Kochflächen oder ähnlichen Haushaltsgeräten aus Glas oder Glaskeramik, Anwendungen im Consumerelektronik-Bereich, wie Abdeckungen von elektronischen Anzeigen und Touchscreens, sowie auch für Uhrengläser, welche eine ebene oder leicht gekrümmte Oberfläche aufweisen können. Unter einem gekrümmten Uhrenglas kann auch eine auf beispielsweise der Datumsanzeige auf dem Uhrenglas aufgeklebte oder eingearbeitete Linse, beispielsweise mit einem Durchmesser von 7 mm und einer Pfeilhöhe, d.h. der Höhe der Linse von einer gedachten Planfläche am Rand der gekrümmten Fläche bis zum Scheitel der gekrümmten Fläche, von 0,4 mm verstanden werden. Bei solchen leicht gekrümmten Uhrgläsern kann ebenfalls die erfindungsgemäße Antireflexbeschichtung mit langlebigem Kratzschutz aufgetragen werden.

Allgemein kann gemäß dieser Weiterbildung der Erfindung also eine gekrümmte, insbesondere eine linsenförmige Oberfläche des Substrats mit der erfindungsgemäßen Beschichtung beschichtet sein.

Die Erfindung wird nachfolgend anhand von Ausführungsbeispielen und unter Bezugnahme auf die beigeschlossenen Zeichnungen näher erläutert. In den Zeichnungen bezeichnen gleiche Bezugszeichen gleiche oder entsprechende Elemente. Es zeigen:

Fig 1 ein Ausführungsbeispiel eines Substrates mit Antireflexbeschichtung,

Fig. 2 Reflektivitäten eines unbeschichteten und beschichteten Glassubstrates als Funktion der Wellenlänge,

Fig. 3 Balkendiagramme der prozentualen Zunahme des Haze-Wertes nach verschiedenen Abrasionsbelastungen unbeschichteter und beschichteter Glassubstrate,

Fig. 4A bis Fig. 4F AFM-Aufnahmen an erfindungsgemäß abgeschiedenen Schichten,

Fig. 5A bis 5C Ausführungsbeispiele von prinzipiellen Spannungsverläufen am Sputtertarget zur Abscheidung von Antireflexbeschichtungen, und die

Fig. 6 und Fig. 7 Verläufe der Anteile von Schichtbestandteilen in Richtung senkrecht zur Oberfläche.

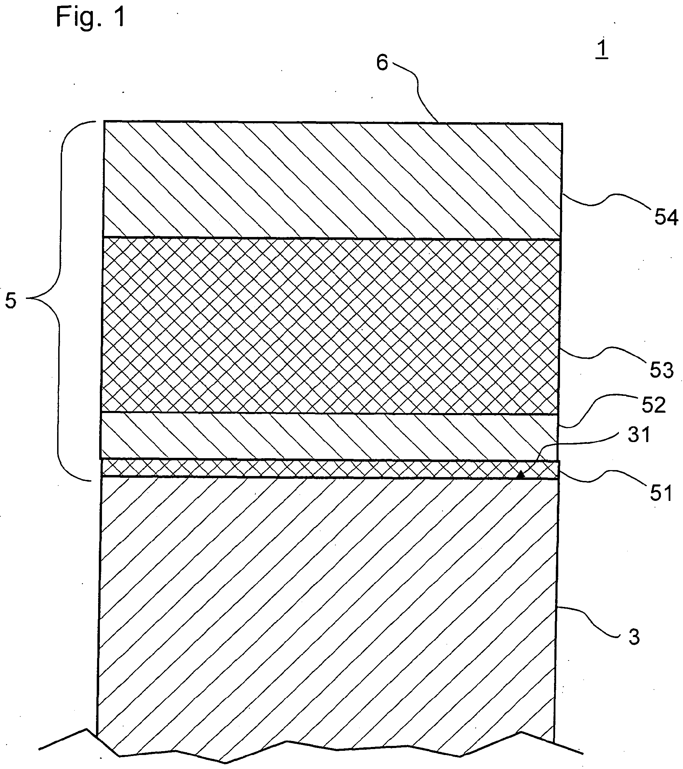

Das in Fig. 1 gezeigte Beispiel eines Erzeugnisses 1 mit einem beschichteten Substrat 3 basiert auf einer Antireflexbeschichtung 5 mit insgesamt vier Lagen. Typischerweise ist das Substrat 3 scheiben- oder plattenförmig, wobei die Antireflexbeschichtung 5 auf einer Seite 31 des Substrates 3 abgeschieden ist.

In der Antireflexbeschichtung 5 wechseln sich Lagen mit höherem Brechungsindex und Lagen mit niedrigerem Brechungsindex ab. Dabei sind die Lagen 52, 54 aus Siliziumoxid mit einem Anteil von Aluminium zusammengesetzt, so daß das Verhältnis der Stoffmengen von Aluminium zu Silizium größer als 0,05, vorzugsweise größer als 0,08 beträgt, die Stoffmenge von Silizium aber gegenüber der Stoffmenge von Aluminium überwiegt. Vorzugsweise beträgt das Verhältnis der Stoffmengen von Aluminium zu Silizium etwa 0,075 bis 0,125, besonders bevorzugt etwa 0,1. Diese Lagen 52, 54 wirken daher, da sie vorwiegend Siliziumoxid enthalten, niedrigbrechend.

Die Lagen 51, 53 sind demgegenüber Lagen mit höherem Brechungsindex und bestehen aus Siliziumnitrid, ebenfalls mit einem Anteil von Aluminium. Vorzugsweise ist das Verhältnis der Stoffmengen von Aluminium und Silizium in allen Lagen im Wesentlichen gleich.

Um eine möglichst hohe mechanische Beständigkeit zu erlangen, wird als Startschicht die mechanisch beständigere Komponente, also Siliziumnitrid, beziehungsweise aluminiumdotiertes Siliziumnitrid als dünne Schicht eingesetzt, da diese das Wachstum des übrigen Wechselschichtsystems bestimmt. Anschließend folgt eine dünne aluminiumdotierte $SiO_2$ Schicht, gefolgt von einer dicken aluminiumdotierten $Si_3N_4$ Beschichtung, welche die Resistenz nach Außen bewirkt. Eine anschließende dünnere aluminiumdotierte $SiO_2$ Schicht wird so abgeschieden, dass die gewünschte Entspiegelung möglich ist und gleichzeitig bei einer möglichen Entfernung dieser Schicht das übrige System optisch nicht auffälliger erscheint.

Ein derartiger Schichtaufbau mit vier Lagen erweist sich als sehr beständig und ist in der Lage, die Reflektivität eines Glassubstrates, wie etwa eines Borosilikatglases im sichtbaren Spektralbereich auf unter 1% abzusenken. Zudem sind Schichtsysteme mit vier Schichten noch kostengünstig herstellbar.

Abweichende Designs auf Basis von 4 Schichten, welche z.B. mit einer niedrigbrechenden aluminiumdotierten Siliziumoxid-Lage als Haftvermittlerschicht beginnen, zeigten geringere Beständigkeit auf Borosilikatgläsern.

Gemäß dem prinzipiellen, in Fig. 1 gezeigten Aufbau ist in Weiterbildung der Erfindung, ohne Beschränkung auf die speziellen Schichtdicken des in Fig. 1 gezeigten Beispiels mit einem Schichtstapel aus vier aufeinanderfolgenden Lagen, bei welcher die unterste Lage eine siliziumnitrid-haltige höherbrechende Lage ist, wobei die weitere siliziumnitrid-haltige höherbrechende Lage, welche die oberste hochbrechende Lage des Schichtstapels bildet, die größte Schichtdicke innerhalb des Schichtstapels aufweist, und wobei die oberste Lage des Schichtstapels eine Lage mit niedrigerem Brechungsindex aus Siliziumoxid mit einem Anteil von Aluminium bildet und die zweitgrößte Schichtdicke unter den Lagen des Schichtstapels aufweist, und wobei die erste Lage und die zweite Lage, welche wie die oberste Lage eine Lage mit niedrigerem Brechungsindex aus Siliziumoxid mit einem Anteil von Aluminium ist, zusammengesetzt eine Schichtdicke aufweisen, die dünner als die Schichtdicke der obersten Lage ist.

Die unterste Lage und die darauffolgende Lage, welche wie die oberste Lage eine Lage mit niedrigerem Brechungsindex aus Siliziumoxid mit einem Anteil von Aluminium ist, sind vorzugsweise sehr dünn, insbesondere ist die zusammengesetzte Schichtdicke beider Lagen dünner als die Schichtdicke der obersten, vierten Lage.

Bei dem in Fig. 1 gezeigten, speziellen Beispiel betragen die Schichtdicke der untersten Lage 13 Nanometer, die Schichtdicke der darauffolgenden Lage 34 Nanometer, die Schichtdicke der weiteren Siliziumnitrid-haltigen höherbrechenden Lage, welche die zweitoberste Lage des Schichtstapels und damit die oberste hochbrechende Lage des Schichtstapels bildet 127 Nanometer und die Schichtdicke der obersten Lage 84 Nanometer. Die kombinierte Schichtdicke der untersten und darauffolgenden Lage ist demgemäß, wie oben beschrieben mit 47 Nanometern dünner als die Schichtdicke der obersten Lage.

Ohne Beschränkung auf das dargestellten Beispiel werden folgende Schichtdickenbereiche bevorzugt: für die unterste Lage 5 bis 40 Nanometer, für die darauffolgende Lage 10 bis 40 Nanometer, für die darauffolgende Lage, welche die zweitoberste Lage des Schichtstapels und damit die oberste hochbrechende Lage des Schichtstapels bildet 100 bis 200 Nanometer, vorzugsweise mehr als 120 Nanometer, und für die oberste Lage 60 bis 120 Nanometer.

Das vorstehend erläuterte Schichtdesign, wie es beispielhaft in Fig. 1 gezeigt ist, eignet sich besonders gut für Glas- und Glaskeramik-Substrate. Ist demgegenüber das Substrat sehr hart, wie dies bei Saphirgläsern, etwa zur Verwendung als Uhrengläser der Fall ist, so ist es für die Festigkeit und Abriebbeständigkeit von Vorteil, wenn eine zusätzliche dünne Schicht verwendet wird. Dabei wird mit einer dünnen Siliziumoxid-Schicht in Kontakt mit dem Substrat begonnen, auf welcher ein Schichtstapel mit vier Lagen, wie vorstehend erläutert abgeschieden wird.

Gemäß einer Weiterbildung der Erfindung ist daher ein Substrat, insbesondere ein Hartstoff-Substrat, besonders bevorzugt ein Saphirglas-Substrat vorgesehen, auf welchem eine aluminiumhaltige Siliziumoxid-Schicht und auf der aluminiumhaltigen Siliziumoxid-Schicht ein Schichtstapel mit den oben angegebenen Dickenverhältnissen abgeschieden ist. Der auf der aluminiumhaltigen Siliziumoxidschicht abgeschiedene Schichtstapel umfasst also wiederum vier aufeinanderfolgenden Lagen, bei welcher die unterste Lage eine Siliziumnitrid-haltige höherbrechende Lage ist, wobei die weitere Siliziumnitrid-haltige höherbrechende Lage, welche die oberste hochbrechende Lage des Schichtstapels bildet, die größte Schichtdicke innerhalb des Schichtstapels aufweist, und wobei die oberste Lage des Schichtstapels eine Lage mit niedrigerem Brechungsindex aus Siliziumoxid mit einem Anteil von Aluminium bildet und die zweitgrößte Schichtdicke unter den Lagen des Schichtstapels aufweist, und wobei die erste Lage und die zweite Lage, welche wie die oberste Lage eine Lage mit niedrigerem Brechungsindex aus Siliziumoxid mit einem Anteil von Aluminium ist, zusammengesetzt eine Schichtdicke aufweisen, die dünner als die Schichtdicke der obersten Lage ist. Nicht nur die zusammengesetzten Schichtdicken der beiden untersten Lagen des Schichtstapels sind dabei bevorzugt geringer als die Schichtdicke der obersten Lage, sondern auch die kombinierte Schichtdicke der beiden untersten Lagen des Schichtstapels und der in Kontakt mit dem Substrat abgeschiedenen aluminiumhaltigen Siliziumoxidschicht.

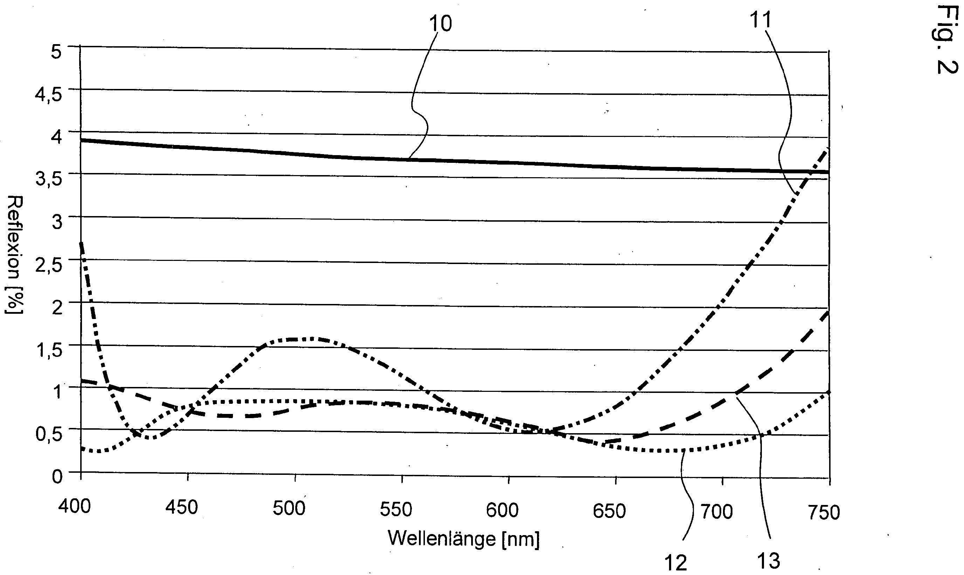

Die sich auf Basis eines wie in Fig. 1 gezeigten Designs mit einer vierlagigen Antireflexbeschichtung ergebenden spektralen Reflexionskurven sind in der Abbildung 2 dargestellt. Die Kurve 10 bezeichnet die spektrale Reflektivität eines unbeschichteten Borosilikat-Glassubstrats. Die Kurve 11 ist die Reflektivität eines solchen Glassubstrats, welches mit einer konventionellen dreilagigen Entspiegelungsschicht beschichtet ist. Kurve 12 zeigt die Reflektivität einer mit Magnetronsputtern auf einem Borosilikat-Glassubstrat abgeschiedenen, erfindungsgemäßen vierlagigen Antireflexbeschichtung. Kurve 13 zeigt ebenfalls die Reflektivität einer solchen Beschichtung, diesmal abgeschieden durch hochenergetische Pulse, beziehungsweise mit dem HiPIMS-Verfahren.

Wie anhand von Fig. 2 belegt wird, lassen sich mit den erfindungsgemäßen Schichtstapeln Entspiegelungen mit einer Reduzierung der Reflektivität von mehr als 3% mit neutralem Farbeindruck erzielen. Die Reflektivität liegt im sichtbaren Spektralbereich weitgehend bei unter 1%.

Die Wirkung der mechanischen Beständigkeit der erfindungsgemäßen Antireflexbeschichtung wurde sowohl anhand dem in der Norm ANSI/SAE Z26.1-1996 abgebildeten Tabertest, als auch anhand eines Sandrieseltests und eines Abrasionstests (PEI Test, Bayertest) untersucht. Dies hat den Hintergrund, dass es unterschiedliche Arten der mechanischen Belastung gibt und der Tabertest nur das Laufen der Taberräder auf der Oberfläche abbildet. Durch die Verwendung des Sandrieseltests wird die Wirkung von Sandkörnern auf beschichtete Scheiben, wie beispielsweise die Scheiben von Fahrzeugen und durch den Abriebtest die Abrasionsbelastung von z.B. Sandkörnern auf Scheibenwischern simuliert. Die verschiedenen Tests wurden durchgeführt, um eine sinnvolle Aussage zur Belastbarkeit der Oberfläche durch die gemeinsame Bewertung der Tests zu erhalten.

Durch die Nutzung der Sputtertechnologie, mit welcher prinzipiell sehr dichte Schichten und Schichtsysteme möglich sind, gelingt es die mechanische Beständigkeit der Oberfläche durch ein dünnes AR - Schichtsystem mit Schichtdicken im Bereich von insgesamt 250-300nm zu verbessern. Dies funktioniert im Gegensatz zu tribologischen Schichten, welche in der Regel deutlich dicker als 1μm sind, bereits bei vergleichsweise sehr dünnen Schichtdicken.

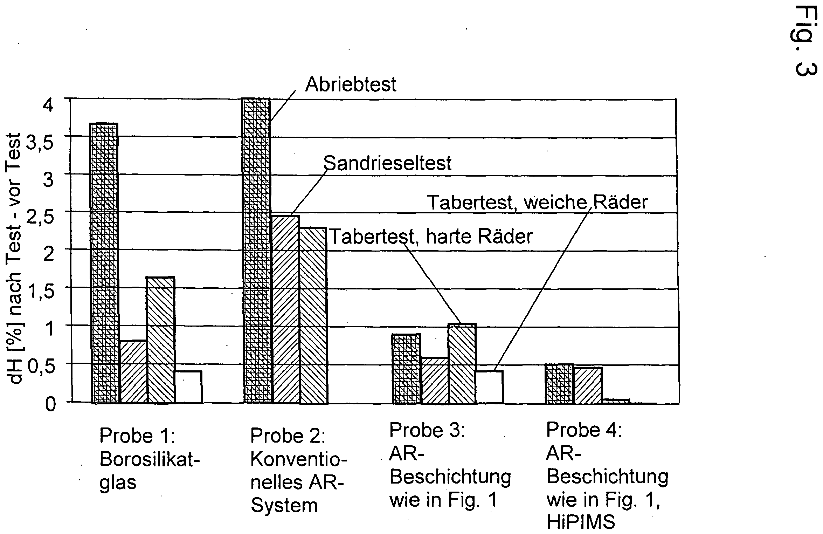

Die Ergebnisse der Tests sind in Fig. 3 als Balkendiagramm dargestellt. Es wurde eine Messung der prozentualen Zunahme des Haze-Wertes an den gleichen Substraten durchgeführt, die auch der in Fig. 2 dargestellten Messung zugrundelagen. In Fig. 3 zeigen die Balken für jede Probe von links nach rechts die Zunahme des Haze-Werts nach einem Bayertest, nach einem Sandrieseltest, nach einem Tabertest mit harten Rädern und einem Tabertest mit weichen Rädern an. Die Haze-Messung erfolgt gemäß dem Standard ASTM D1003-95. Dabei wird bei dem durch die Probe transmittierten Licht der Anteil von Streulicht mit der Intensität des gesamten transmittierten Lichts verglichen. Die Messwerte in Fig. 3 geben somit die prozentuale Zunahme des Streulichtanteils aufgrund von Kratzern und anderen Beschädigungen der Probenoberfläche nach den jeweiligen Abriebstests wieder.

Beim Tabertest rollen Metallräder entlang eines kreisförmigen Pfades auf der Beschichtung ab. Dabei ist zusätzlich die Laufrichtung der Räder gegenüber der Tangente des Pfades verkippt, so dass beim Abrollen eine Reibung der Lauffläche der Räder auf der zu testenden Oberfläche erzeugt wird. Beim Sandrieseltest fällt Sand aus einer festgelegten Höhe, die für die dargestellten Messungen zwei Meter betrug, auf die zu testende Oberfläche. Beim Abriebtest gemäß dem Bayertest wird das zu prüfende Substrat in eine Wanne eingelegt und mit Sand bedeckt. Die Wanne wird oszillierend bewegt, so dass der Sand, welcher gemäß ASTM F735 mit mehr als 1cm aufgehäuft in der Wanne vorliegt unter seinem Eigengewicht auf der zu prüfenden Oberfläche reibt.

Wie anhand von Fig. 3 zu erkennen ist, ist eine konventionelle Antireflexbeschichtung (Probe 2) hinsichtlich der Abriebsfestigkeit bei allen Tests sogar schlechter als das unbeschichtete Borosilikatglas (Probe 1). Die mit Magnetronsputtern erfindungsgemäß beschichtete Probe (Probe 3) zeigt beim Abriebtest eine sehr deutliche Verbesserung der Beständigkeit. Bei den anderen Tests zeigt sich immerhin eine erkennbare Verbesserung. Lediglich beim Tabertest mit weichen Rädern ist die Verbesserung nicht deutlich zu erkennen, jedoch bereits auf sehr niedrigem Niveau.

Bei Probe 4, die eine entsprechend zu Probe 3, jedoch mit HiPIMS abgeschiedene erfindungsgemäße Antireflexbeschichtung aufweist, ist eine weitere deutliche Verbesserung der Abriebfestigkeit, hier bei allen Tests festzustellen. Insbesondere bei den Tabertests ist eine Verbesserung gegenüber den mit herkömmlichem Magnetronsputtern abgeschiedenen Lagen der Probe 3 zu erkennen. Die Probe besteht die Tabertests dabei sogar mit kaum noch messbarer Zunahme des Haze-Werts. Insgesamt ist die Zunahme des Haze-Wertes bei allen Tests bei Probe 4 so gering, dass die Abriebspuren gar nicht, oder allenfalls kaum mit dem bloßen Auge erkennbar sind.

Gerade die hohe Beständigkeit der Probe 4 gegenüber den Tabertests kann wahrscheinlich auf die äußerst glatte Oberfläche der Antireflexbeschichtung zurückgeführt werden.

Die nachfolgende Tabelle 1: gibt dazu mit einem Rasterkraftmikroskop gemessene Rauheitswerte für drei verschiedene Flachglasproben an (Probenbezeichnungen: 01-A, 02 - H, und 03 - F), wobei die Beschichtungen auf den Proben jeweils mit dem HiPIMS-Verfahren, also mit einer Anregung des Sputter-Plasmas durch ein gepulstes Feld mit Pulsen einer Leistungsdichte von mindestens 100 Watt pro Quadratzentimeter der Targetfläche abgeschieden wurden. In der Tabelle sind die Messwerte von jeweils zwei Messungen (Messung 1, Messung 2) angegeben.

Tabelle 1:

| Probe | Messung 1 | | Messung 2 | |
|---|---|---|---|---|
| | Rms [nm] | Ra [nm] | Rms [nm] | Ra [nm] |
| 01 - A | 0,9 | 0,8 | 1 | 0,8 |
| 02 - H | 0,5 | 0,4 | 0,6 | 0,4 |
| 03 - F | 0,3 | 0,2 | 0,3 | 0,3 |

Der absolute Fehler der Messung kann grob zu ± 30 % abgeschätzt werden.

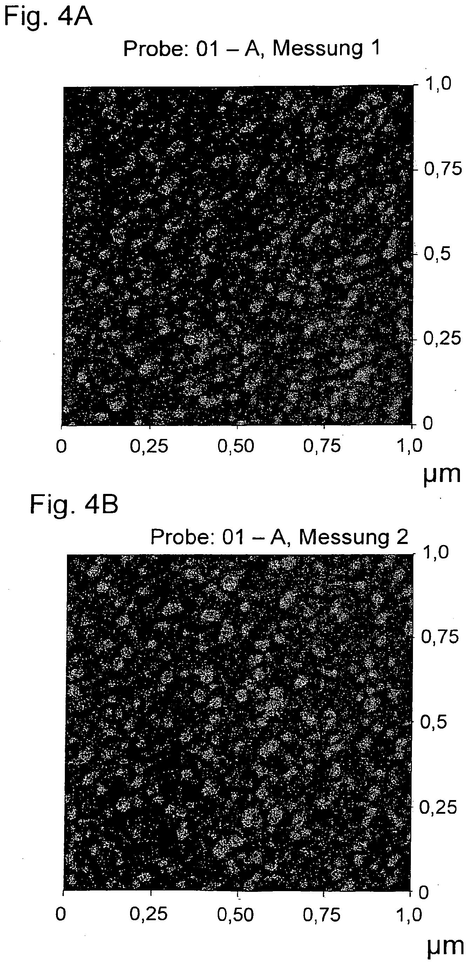

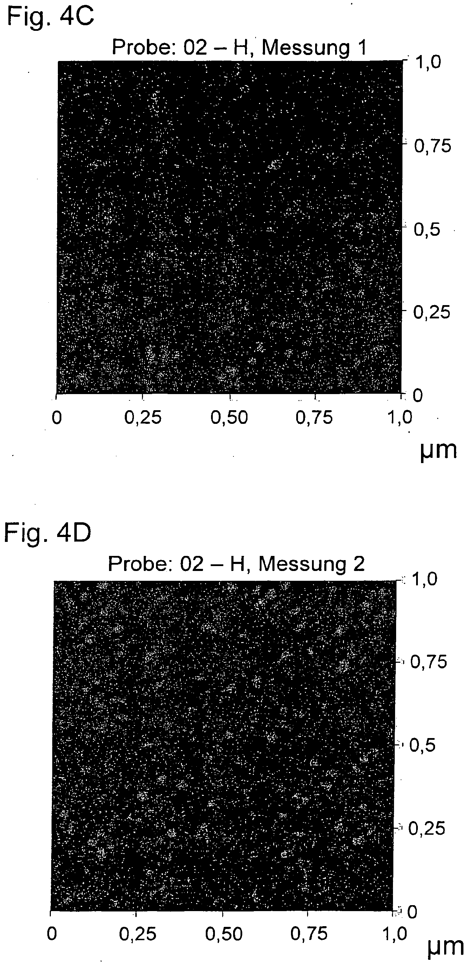

Die Fig. 4A bis 4C zeigen die zugehörigen AFM-Aufnahmen. Dabei sind die Probennahmen und die Nummer der Messung in den Figuren entsprechend der vorstehenden Tabelle bezeichnet. Der abgebildete Ausschnitt der Schichtoberflächen beträgt jeweils 1 Mikrometer auf 1 Mikrometer.

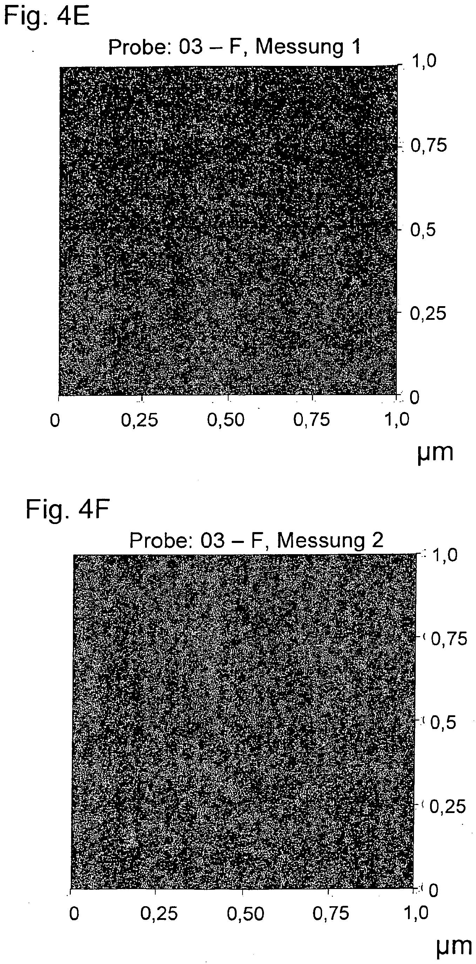

Anhand der Fig. 4C bis 4F ist zu erkennen, dass die Rauhigkeit der Schichten selbst mit einem Rasterkraftmikroskop kaum noch messbar ist. Bei den Figuren 4E und 4F erscheint das Mikroskopbild daher in fast einheitlichem Grauton. Zumindest die beiden Proben 02 - H und 03 - F zeigen, dass sich mit dem HiPIMS-Verfahren aluminiumdotierte Siliziumoxid- und Siliziumnitrid-Schichten gemäß der Erfindung mit Rauhigkeitswerden Ra und RMS deutlich unter 1 Nanometer, im Allgemeinen sogar unter 0,75 Nanometern ohne weiteres herstellen lassen.

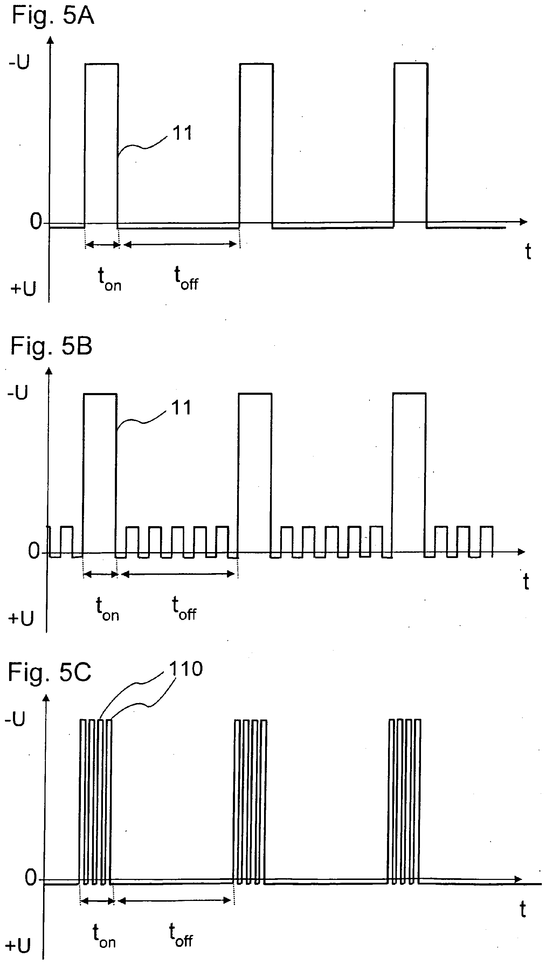

Anhand der Fig. 5A bis 5C werden nachfolgend die Spannungsverläufe gemäß verschiedener Ausführungsbeispiele des HiPIMS-Sputterns, wie es für die Abscheidung der erfindungsgemäßen Antireflexbeschichtungen verwendet werden kann, erläutert. In den Figuren ist jeweils schematisch die Kathodenspannung, beziehungsweise die am Sputtertarget angelegte Spannung als Funktion der Zeit aufgetragen.

Fig. 5A zeigt einen typischen Spannungsverlauf, bei welchem am Sputtertarget periodisch für eine Zeitdauer $t_{on}$ Pulse 11 mit hoher negativer Spannungen angelegt werden. Zwischen diesen Pulsen, also während einer Pulspause wird die Spannung für eine Zeit $t_{off}$ ausgeschaltet. Gegebenenfalls kann, wie in Fig. 5A auch dargestellt, während der Pulspause eine leicht positive Spannung angelegt werden. Das Tastverhältnis, also das Verhältnis der Zeitdauern $t_{on}/t_{off}$ ist vorzugsweise kleiner als 1/5. Die Wiederholungsfrequenz der Pulse liegt vorzugsweise zwischen 500Hz und 10 kHz.

Bei dem in Fig. 5B gezeigten Beispiel wird während der Pulspausen, also während der Zeitdauern $t_{off}$ das Plasma aufrechterhalten. Dies ist günstig, da in diesem Fall instantan beim Einsetzen eines HiPIMS Pulses aufgrund der vorhandenen Ionen der Sputterprozess einsetzt. Dies hat sich als günstig für die Abscheideraten erwiesen.

Um das Plasma aufrechtzuerhalten, wird eine DC-Spannung oder wie in 5B gezeigt eine Wechselspannung an das Target angelegt, wobei die eingetragene Leistung hier aber wesentlich geringer ist, als die Leistung der Pulse. Vorzugsweise ist die Leistungsdichte während der Pulspause mindestens einen Faktor 10, besonders bevorzugt mindestens einen Faktor 50 kleiner, verglichen mit den Pulsen.

Fig. 5C zeigt eine weitere Variante. Hier sind die Pulse 11 aufgespalten in mehrere, noch kürzere Pulse 110 mit im Vergleich zur Pulspause sehr kurzen Zeitabständen. Mit anderen Worten werden die Pulse 11 hier als Pulsserien dargestellt.

Diese Variante hat sich als günstig erwiesen, um steile Einschaltflanken der Pulse zu erzielen und ein Abfallen der Ströme während der Pulslänge zu vermeiden. Damit wird sichergestellt, dass niedrigenergetischere Teilchen erzeugt werden, welche zu weniger glatten Schichten führen. Selbstverständlich können die Varianten der Fig. 5B und 5C auch miteinander kombiniert werden.

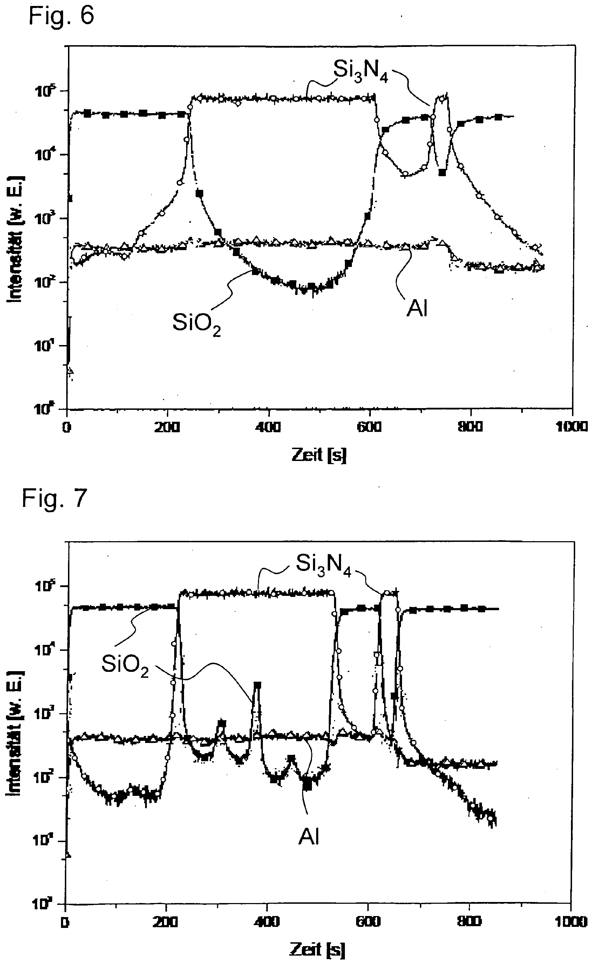

Die Fig. 6 und Fig. 7 zeigen Verläufe der Mengen oder Konzentrationen von Schichtbestandteilen erfindungsgemäßer Antireflexbeschichtungen. Die Verläufe wurden mit Flugzeit-Sekundärionen-Massenspektroskopie (TOF-SIMS) erhalten. Die auf der Abszisse aufgetragenen Zeitwerte geben die Dauer des Sputterprozesses wieder. Demgemäß beginnt die Messung bei der Zeit t=0 an der Oberfläche der Antireflexbeschichtung.

Bei beiden Messungen wurde ein Schichtsystem, wie es in Fig. 1 gezeigt ist, verwendet.

In den beiden Figuren ist die Messung der Konzentrationsverläufe der Bestandteile Siliziumoxid, Siliziumnitrid und Aluminium dargestellt. Da bei den gezeigten Verläufen Signale von Aluminium-Ionen ausgewertet wurden, geben die Figuren nicht wieder, ob das Aluminium als Oxid oder als Nitrid in den jeweiligen Lagen vorhanden ist. Die entsprechenden Kurven für Aluminiumnitrid und Aluminiumoxid wurden der Übersichtlichkeit fortgelassen, zeigen aber ebenso wie die Verläufe von Siliziumoxid und Siliziumnitrid eine entsprechende Korrelation zu den einzelnen Lagen, wobei in den Siliziumnitrid-Lagen Aluminium im Wesentlichen als Aluminiumnitrid und in den Siliziumoxid-Lagen im Wesentlichen als Aluminiumoxid vorliegt.

Bei den in Fig. 6 dargestellten Messwerten wurde eine mit herkömmlichem Magnetronsputtern abgeschiedene Antireflexbeschichtung und bei den in Fig. 7 dargestellten Messwerten eine mit HiPIMS abgeschiedene Antireflexbeschichtung als Probe verwendet. Die aufwändiger herzustellende, mit HiPIMS abgeschiedene Antireflexbeschichtung zeigt schärfere Übergänge an den Grenzflächen zwischen den einzelnen Lagen. Die als Stufen in den Konzentrationen erkennbaren Grenzflächen werden bei dem in Fig. 7 gezeigten Beispiel bei etwa 220, 520, 620 und 660 Sekunde Sputterdauer erreicht. Die nach der TOF-SIMS-Messung gemäß Fig. 6 etwas weniger scharf begrenzten Grenzflächen der Lagen führen zu einer leichten Vermischung der Phasen. Mit anderen Worten sind in den Siliziumnitrid-Lagen kleine Anteile von Siliziumoxid und umgekehrt in den Siliziumoxid-Lagen kleine Anteile von Siliziumnitrid enthalten. Durch die erhöhte Verdichtung der Schichten, die mit HiPIMS abgeschieden wurden, ergibt sich eine höhere Abriebfestigkeit. Dem steht allerdings ein höherer Fertigungsaufwand gegenüber, da die HiPIMS-Abscheidung energieintensiver ist und geringere Abscheideraten zeigt.

**Patentansprüche**

**1.** Beschichtetes Substrat (3), welches

- auf zumindest einer Seite eine mehrlagige Antireflexbeschichtung (5) aufweist, welche
- aus Lagen mit verschiedenen Brechungsindizes aufgebaut ist, wobei sich Lagen mit höherem Brechungsindex und Lagen mit niedrigerem Brechungsindex abwechseln, wobei
- die Lagen mit niedrigerem Brechungsindex aus Siliziumoxid mit einem Anteil von Aluminium aufgebaut sind, bei welchen
- das Verhältnis der Stoffmengen von Aluminium zu Silizium größer als 0,05, vorzugsweise größer als 0,08 beträgt, die Stoffmenge von Silizium aber gegenüber der Stoffmenge von Aluminium überwiegt, und wobei
- die Lagen mit höherem Brechungsindex ein Silizid, Oxid oder Nitrid enthalten, **dadurch gekennzeichnet, dass** die Oberfläche der Antireflexbeschichtung eine mittlere Rauheit und eine quadratische Rauheit aufweist, die bezogen auf eine Fläche von einem Quadratmikrometer jeweils weniger als 1,5 Nanometer beträgt.

2. Beschichtetes Substrat gemäß dem vorstehenden Anspruch, **dadurch gekennzeichnet, dass** die Lagen mit höherem Brechungsindex aus Siliziumnitrid mit einem Anteil von Aluminium aufgebaut sind, bei welchen

- das Verhältnis der Stoffmengen von Aluminium zu Silizium größer als 0,05, vorzugsweise größer als 0,08 beträgt.

3. Beschichtetes Substrat gemäß einem der vorstehenden Ansprüche, **dadurch gekennzeichnet, dass** die Oberfläche der Antireflexbeschichtung durch eine Lage mit niedrigerem Brechungsindex aus Siliziumoxid mit einem Anteil von Aluminium gebildet wird.

4. Beschichtetes Substrat gemäß einem der vorstehenden Ansprüche, **dadurch gekennzeichnet, dass** die Antireflexionsbeschichtung eine Schichtdicke im Bereich von insgesamt 200 bis 400 Nanometern aufweist.

5. Beschichtetes Substrat gemäß einem der vorstehenden Ansprüche, **dadurch gekennzeichnet, dass** die Antireflexbeschichtung zumindest zwei Lagen mit höherem Brechungsindex und zumindest zwei Lagen mit niedrigerem Brechungsindex aufweist.

6. Beschichtetes Substrat gemäß dem vorstehenden Anspruch, **gekennzeichnet durch** eine Antireflexbeschichtung mit einem Schichtstapel aus vier aufeinanderfolgenden Lagen, bei welcher die unterste Lage eine siliziumnitrid-haltige höherbrechende Lage ist, wobei die weitere siliziumnitrid-haltige höherbrechende Lage, welche die oberste hochbrechende Lage des Schichtstapels bildet, die größte Schichtdicke innerhalb des Schichtstapels aufweist, und wobei die oberste Lage des Schichtstapels eine Lage mit niedrigerem Brechungsindex aus Siliziumoxid mit einem Anteil von Aluminium bildet und die zweitgrößte Schichtdicke unter den Lagen des Schichtstapels aufweist, und wobei die erste Lage und die zweite Lage, welche wie die oberste Lage eine Lage mit niedrigerem Brechungsindex aus Siliziumoxid mit einem Anteil von Aluminium ist, zusammengesetzt eine Schichtdicke aufweisen, die dünner als die Schichtdicke der obersten Lage ist.

7. Beschichtetes Substrat gemäß dem vorstehenden Anspruch, bei welchem auf dem Substrat eine aluminiumhaltige Siliziumoxid-Schicht und auf der aluminiumhaltigen Siliziumoxid-Schicht der Schichtstapel mit den vier aufeinanderfolgenden Lagen abgeschieden ist.

8. Beschichtetes Substrat gemäß einem der vorstehenden Ansprüche, wobei das Substrat eine Glas- oder Glaskeramik- oder Saphirglas-Scheibe, ein synthetisches Quarzglas-Substrat, ein Kristall, insbesondere für optische Zwecke, ein optisches Glas oder ein Filterglas ist.

9. Beschichtetes Substrat gemäß einem der vorstehenden Ansprüche, **dadurch gekennzeichnet, dass** eine gekrümmte, insbesondere eine linsenförmige Oberfläche des Substrats mit der Antireflexionsbeschichtung beschichtet ist.

10. Verfahren zur Herstellung eines beschichteten Substrats, bei welchem

- auf zumindest einer Seite des Substrats eine mehrlagige Antireflexbeschichtung aufgebracht wird, welche
- durch sukzessive Abscheidung aus Lagen mit verschiedenen Brechungsindizes aufgebaut wird, wobei sich Lagen mit höherem und Lagen mit niedrigerem Brechungsindex abwechseln, wobei
- die Lagen mit niedrigerem Brechungsindex aus Siliziumoxid mit einem Anteil von Aluminium aufgebaut werden, bei welchen
- das Verhältnis der Stoffmengen von Aluminium zu Silizium größer als 0,05, vorzugsweise größer als 0,08 beträgt, die Stoffmenge von Silizium aber gegenüber der Stoffmenge von Aluminium überwiegt, und wobei
- Silizid-, Oxid oder Nitrid-haltige Lagen als Lagen mit höherem Brechungsindex abgeschieden werden, und wobei die Antireflexionsbeschichtung durch Magnetronsputtern abgeschieden wird, wobei zur Anregung des Plasmas ein gepulstes Feld verwendet wird, wobei die Pulse eine Leistungsdichte von mindestens 100 Watt pro Quadratzentimeter der Targetfläche aufweisen, so dass die Oberfläche der Antireflexbeschichtung eine mittlere Rauheit und eine quadratische Rauheit aufweist, die bezogen auf eine Fläche von einem Quadratmikrometer jeweils weniger als 1,5 Nanometer beträgt.

**11.** Verfahren gemäß dem vorstehenden Anspruch, **dadurch gekennzeichnet, dass** in den Pausen zwischen den Pulsen das Plasma aufrechterhalten wird.

**Claims**

**1.** Coated substrate, (3) which

- comprises a multilayer antireflection coating (5) on at least one side, which coating
- is built up from layers having different refractive indices, wherein layers having a higher refractive index alternate with layers having a lower refractive index, wherein
- the layers having a lower refractive index are built up from silicon oxide with a proportion of aluminium, in which layers
- the ratio of the quantities of aluminium to silicon is greater than 0.05, preferably greater than 0.08, the quantity of silicon being predominant relative to the quantity of aluminium, and wherein
- the layers having a higher refractive index contain a silicide, oxide or nitride, **characterised in that** the surface of the antireflection coating has an average roughness and a root-mean-squared roughness of less than 1.5 nanometres in each case with respect to an area of one square micrometre.

**2.** Coated substrate as claimed in the preceding claim, **characterised in that** the layers having a higher refractive index are built up from silicon nitride with a proportion of aluminium, in which

- the ratio of the quantities of aluminium to silicon is greater than 0.05, preferably greater than 0.08.

**3.** Coated substrate as claimed in any one of the preceding claims, **characterised in that** the surface of the antireflection coating is formed by a layer having a lower refractive index made from silicon oxide with a proportion of aluminium.

**4.** Coated substrate as claimed in any one of the preceding claims, **characterised in that** the antireflection coating has a layer thickness in the range of a total of 200 to 400 nanometres.

**5.** Coated substrate as claimed in any one of the preceding claims, **characterised in that** the antireflection coating comprises at least two layers having a higher refractive index and at least two layers having a lower refractive index.

**6.** Coated substrate as claimed in the preceding claim, **characterised by** an antireflection coating with a layer stack of four successive layers in which the bottom layer is a silicon nitride-containing higher refractive layer, wherein the further silicon nitride-containing higher refractive layer which forms the top high refractive layer of the layer stack, has the largest layer thickness within the layer stack, and wherein the top layer of the layer stack forms a layer having a lower refractive index made from silicon oxide with a proportion of aluminium and has the second largest layer thickness of the layers of the stack, and wherein the first layer and the second layer, which - like the top layer - is a layer having a lower refractive index made from silicon oxide with a proportion of aluminium, have when combined a layer thickness with is thinner than the layer thickness of the top layer.

**7.** Coated substrate as claimed in the preceding claim, in which an aluminium-containing silicon oxide layer is deposited on the substrate and the layer stack with the four successive layers is deposited on the aluminium-containing silicon oxide layer.

**8.** Coated substrate as claimed in any one of the preceding claims, wherein the substrate is a glass or glass ceramic or sapphire glass pane, a synthetic quartz glass substrate, a crystal, particularly for optical purposes, an optical glass or a filter glass.

**9.** Coated substrate as claimed in any one of the preceding claims, **characterised in that** a curved, in particular lenticular, surface of the substrate is coated with an antireflection coating.

**10.** Method for producing a coated substrate, in which

- on at least one side of the substrate, a multilayer antireflection coating is applied which
- is built up by successive deposition of layers having different refractive indices, wherein layers having a higher refractive index alternate with layers having a lower refractive index, wherein
- the layers having a lower refractive index are built up from silicon oxide with a proportion of aluminium, in which layers
- the ratio of the quantities of aluminium to silicon is greater than 0.05, preferably greater than 0.08, the quantity of silicon being predominant relative to the quantity of aluminium, and wherein
- silicide-containing, oxide-containing or nitride-containing layers are deposited as layers having a higher refractive index, and wherein the antireflection coating is deposited by magnetron sputtering, wherein a pulsed field is used to excite the plasma, wherein the pulses have a power density of at least 100 watts per square centimetre of the target surface and so the surface of the antireflection coating has an average roughness and a root mean squared roughness of less than 1.5 nanometres in each case with respect to an area of one square micrometre.

**11.** Method as claimed in the preceding claim, **characterised in that** the plasma is maintained in the intervals between the pulses.

**Revendications**

**1.** Substrat revêtu (3) qui :

- présente au moins sur une face un revêtement antireflet multicouches (5), qui
- se compose de couches ayant différents indices de réfraction, des couches ayant un indice de réfraction plus élevé alternant avec des couches ayant un indice de réfraction plus faible,
- les couches ayant un indice de réfraction plus faible se composant d'oxyde de silicium comportant une proportion d'aluminium,
- le rapport des quantités de matière entre l'aluminium et le silicium étant supérieur à 0,05, de préférence supérieur à 0,08, la quantité de matière du silicium excédant cependant la quantité de matière de l'aluminium, et
- les couches ayant un indice de réfraction plus élevé contenant un siliciure, un oxyde ou un nitrure, **caractérisé en ce que** la surface du revêtement antireflet présente une rugosité moyenne et une rugosité quadratique qui sont respectivement inférieures à 1,5 nanomètre par rapport à une surface d'un micromètre carré.

**2.** Substrat revêtu selon la revendication précédente, **caractérisé en ce que** les couches ayant un indice de réfraction plus élevé se composent de nitrure de silicium comportant une proportion d'aluminium, dans lesquelles :

- le rapport des quantités de matière entre l'aluminium et le silicium est supérieur à 0,05, de préférence supérieur à 0,08.

**3.** Substrat revêtu selon l'une des revendications précédentes, **caractérisé en ce que** la surface du revêtement antireflet est formée par une couche ayant un indice de réfraction plus faible constituée d'oxyde de silicium comportant une proportion d'aluminium.

**4.** Substrat revêtu selon l'une des revendications précédentes, **caractérisé en ce que** la surface du revêtement antireflet présente une épaisseur de couche dans la plage de 200 à 400 nanomètres au total.

**5.** Substrat revêtu selon l'une des revendications précédentes, **caractérisé en ce que** la surface du revêtement antireflet présente au moins deux couches ayant un indice de réfraction plus élevé et au moins deux couches ayant un indice de réfraction plus faible.

**6.** Substrat revêtu selon la revendication précédente, **caractérisé par** un revêtement antireflet comprenant un empilement de couches constitué de quatre couches successives, revêtement dans lequel la couche inférieure est une couche à indice de réfraction plus élevé contenant du nitrure de silicium, dans lequel l'autre couche à indice de réfraction plus élevé contenant du nitrure de silicium qui forme la couche à indice de réfraction plus élevé supérieure de l'empilement de couches, présente l'épaisseur de couche la plus importante au sein de l'empilement de couches, et dans lequel la couche supérieure de l'empilement de couches forme une couche ayant un indice de réfraction plus faible constituée d'oxyde de silicium comportant une proportion d'aluminium et la deuxième épaisseur de couche la plus importante parmi les couches de l'empilement de couches, et dans lequel la première couche et la deuxième couche qui est, comme la couche supérieure, une couche ayant un indice de réfraction plus faible constituée d'oxyde de silicium comportant une proportion d'aluminium, présentent une fois assemblées une épaisseur de couche qui est plus mince que l'épaisseur de couche de la couche supérieure.

7. Substrat revêtu selon la revendication précédente, dans lequel une couche d'oxyde de silicium contenant de l'aluminium est déposée sur le substrat et l'empilement de couches constitué de quatre couches successives est déposé sur la couche d'oxyde de silicium contenant de l'aluminium.

8. Substrat revêtu selon l'une des revendications précédentes, dans lequel le substrat est une plaque en verre ou en vitrocéramique ou en verre saphir, un substrat en verre de quartz synthétique, un cristal, en particulier destiné à des fins optiques, un verre optique ou un verre filtrant.

9. Substrat revêtu selon l'une des revendications précédentes, **caractérisé en ce qu'**une surface courbée du substrat, en particulier en forme de lentille, est revêtue du revêtement antireflet.

10. Procédé de fabrication d'un substrat revêtu, selon lequel :

- un revêtement antireflet multicouches est déposé sur au moins une face du substrat, ledit revêtement :

- est constitué par dépôt successif de couches ayant différents indices de réfraction, des couches ayant un indice de réfraction plus élevé alternant avec des couches ayant un indice de réfraction plus faible,
- les couches ayant un indice de réfraction plus faible étant constituées à partir d'oxyde de silicium comportant une proportion d'aluminium,
- le rapport des quantités de matière entre l'aluminium et le silicium est supérieur à 0,05, de préférence supérieur à 0,08, la quantité de matière du silicium excédant cependant la quantité de matière de l'aluminium, et
- des couches contenant du siliciure, de l'oxyde ou du nitrure étant déposées en tant que couches ayant un indice de réfraction plus élevé, et

dans lequel le revêtement antireflet est déposé par pulvérisation magnétron, un champ pulsé étant utilisé pour l'excitation du plasma, la pulsation présentant une densité de puissance d'au moins 100 watts par centimètre carré de la surface cible de telle sorte que la surface du revêtement antireflet présente une rugosité moyenne et une rugosité quadratique qui sont respectivement inférieures à 1,5 nanomètre par rapport à une surface d'un micromètre carré.

11. Procédé selon la revendication précédente, **caractérisé en ce que** le plasma est maintenu pendant les pauses entre les impulsions.

Fig. 1

Fig. 2

## Fig. 3

## Fig. 4A

Probe: 01 – A, Messung 1

## Fig. 4B

Probe: 01 – A, Messung 2

Fig. 4C

Probe: 02 – H, Messung 1

Fig. 4D

Probe: 02 – H, Messung 2

## Fig. 4E

### Probe: 03 – F, Messung 1

μm

## Fig. 4F

### Probe: 03 – F, Messung 2

μm

Fig. 5A

Fig. 5B

Fig. 5C

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050074591 A1
- WO 200137006 A1
- FR 2898295 A1
- FR 2841894 A1
- FR 2889182 A1
- EP 2149540 A1
- JP 2004271480 A
- JP 2006275526 A
- FR 2861386 A1
- WO 2010127845 A1